(19) Europäisches Patentamt
European Patent Office
Office européen des brevets

(11) **EP 1 918 724 A1**

(12) **EUROPÄISCHE PATENTANMELDUNG**

(43) Veröffentlichungstag:
**07.05.2008 Patentblatt 2008/19**

(51) Int Cl.:
***G01R 29/08*** *(2006.01)*

(21) Anmeldenummer: **07019909.6**

(22) Anmeldetag: **11.10.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK RS**

(30) Priorität: **06.11.2006 DE 102006052539**

(71) Anmelder: **Deutsche Bahn AG**
**10782 Berlin (DE)**

(72) Erfinder:
• **Klier, Franz**
  **85296 Rohrbach (DE)**
• **Jank, Steffen**
  **60431 Frankfurt am Main (DE)**
• **Finner, Lars**
  **10829 Berlin (DE)**

(74) Vertreter: **Zinken-Sommer, Rainer**
**Deutsche Bahn AG**
**Patentabteilung**
**Völckerstrasse 5**
**80939 München (DE)**

(54) **Verfahren zur grossflächigen Erfassung stark schwankender niederfrequenter magnetischer Felder, insbesondere im Rahmen der Ermittlung einer elektromagnetischen Verträglichkeit im Bereich stromführender Einrichtungen**

(57) Die Erfindung betrifft ein Verfahren zur großflächigen Erfassung stark schwankender niederfrequenter magnetischer Felder, insbesondere im Rahmen der Ermittlung einer elektromagnetischen Verträglichkeit im Bereich stromführender Einrichtungen, wobei hierfür an sich bekannte Messinstrumente verwendet werden, mit deren Hilfe die jeweilige magnetische Flussdichte an bestimmten Messpunkten eines zu vermessenden Objektes ermittelt wird.

Wobei am zu vermessenden Objekt ein Dauermesspunkt eingerichtet wird, an dem eine Messung der Magnetfeldstärke über einen längeren Zeitraum, vorzugsweise 24 Stunden, durchgeführt wird, parallel und zeitgleich zur Dauermessung an verschiedenen weiteren von der stromführenden Einrichtung beeinflussten Messpunkten des zu vermessenden Objektes schrittweise mehrere jeweils sehr viel kürzere Vergleichsmessungen realisiert werden, die Maximalwerte der Dauermessung zu den zeitgleichen Werten der Vergleichsmessungen und den absoluten Maximalmesswerten der Dauermessung nach folgender Formel in ein Verhältnis gesetzt werden,

$$MW_{x\ max} = \frac{MW_0(t_0) \cdot MW_x(t_x)}{MW_0(t_x)}$$

und anschließend die gesamte bezogene Magnetfeldbelastung des Messobjektes im Zeitraum der Dauermessung umfassend dargestellt wird.

EP 1 918 724 A1

**Beschreibung**

Die Erfindung betrifft ein Verfahren zur großflächigen Erfassung stark schwankender niederfrequenter magnetischer Felder, insbesondere im Rahmen der Ermittlung einer elektromagnetischen Verträglichkeit im Bereich stromführender Einrichtungen, wobei hierfür an sich bekannte Messinstrumente verwendet werden, mit deren Hilfe die jeweilige magnetische Flussdichte an bestimmten Messpunkten eines zu vermessenden Objektes ermittelt wird. Beispielsweise können eisenbahntechnische Anlagen oder Freileitungen der Energieversorger einer elektromagnetischen Verträglichkeitsuntersuchung zugeführt werden.

Bisher wurden derartige Messungen durch gleichzeitiges Messen der Ströme im Umspannwerk bzw. im Unterwerk oder durch zeit- und ressourcenaufwendige Dauermessungen an jedem interessierenden Messpunkt gelöst. Dabei ergibt sich die besondere Problematik, dass Dauer- und Vergleichsmessung nur dann zueinander ins Verhältnis gesetzt werden können, wenn Messwerte verglichen werden, die exakt zum gleichen Zeitpunkt gemessen werden. Zeitlich gekoppelte, digitale Magnetfeldmesssysteme, die an zwei unterschiedlichen Orten gleichzeitig Messwerte erfassen können, sind auf dem Markt nicht erhältlich.

Die elektromagnetische Belastung von Personen, Gebäuden und Grundstücken steht zunehmend im Interesse der Öffentlichkeit, weil elektromagnetische Felder Auswirkungen auf Mensch und Technik haben können. Aus diesem Grunde finden insbesondere im Rahmen von Neu- und Ausbauvorhaben Messungen statt, die der Ermittlung der vorherrschenden elektromagnetischer Felder dienen, die beispielsweise durch stromführende Anlagen erzeugt werden. Insbesondere Röhrenbildschirme oder medizinische Geräte reagieren empfindlich auf störende, niederfrequente magnetische Felder. Aus diesem Grunde sind die magnetischen Felder zu messen, und zwar an jedem relevanten Punkt über lange Zeiträume, um auch betriebliche bedingte Spitzen zu erfassen und um ein aussagekräftiges Ergebnis zu erzielen.

Übliche Messverfahren können dies nicht leisten, da aufgrund der Ressourcenknappheit nur "Momentaufnahmen der magnetischen Belastung" gemacht werden, deren Aussagekräftigkeit sehr begrenzt ist.

Bekannt ist ein Hochfrequenz-Feldstärkehandmessgerät mit einem Gehäuse mit Anzeige und Bedientasten auf einer Oberfläche sowie mit einer über eine Steckverbindung verbindbaren Sonde zum Erfassen der elektrischen Feldstärke (EP 1 445 619 A1).

Mit dieser Lösung können Feldstärken mit der geforderten Genauigkeit gemessen werden. Eine exakte, zeitliche Synchronisation mit einem zweiten, baugleichen Messgerät ist jedoch nicht möglich. Dies ist jedoch eine zwingende Voraussetzung, um zwei Messungen zueinander in Bezug setzen zu können.

Weiterhin ist eine Messanordnung zur Erfassung von Magnetfeldern bekannt, welches sowohl ein Niederfrequenz-Meßsystem und ein Hochfrequenz-Meßsystem als auch ein Verknüpfungsglied zwischen beiden Meßsystemen aufweist (DE 100 62 292 A1).

Diese Messanordnung kann magnetische Felder über einen großen Frequenzbereich mit der geforderten Genauigkeit messen. Auch hier gilt, dass eine exakte, zeitliche Synchronisation mit einem zweiten, baugleichen Messgerät nicht möglich ist. Dies ist eine zwingende Voraussetzung, um zwei Messungen zueinander in Bezug setzen zu können. Um aussagekräftige Ergebnisse zu bekommen, müsste an jedem interessierenden Messort (in der Regel sind sehr viele unterschiedliche Messorte erforderlich) ein derartiges Gerät positioniert werden. Ein solches Vorgehen wäre zu ressourcenaufwendig und damit unwirtschaftlich.

Der Erfindung liegt die Aufgabe zugrunde, ein Verfahren zur Messung der magnetischen Felder in großen Arealen im Bereich gleichermaßen beeinflussender stromführender Anlagen, beispielsweise eisenbahntechnischer Anlagen, zu entwickeln, welches den betrieblich bedingten Schwankungen des Stromes und damit den magnetischen Feldern der Anlagen gerecht wird und aufwendige Langzeit-Einzelmessungen an einer Vielzahl von Messpunkten vermeidet, es erlaubt, die Messergebnisse zueinander in Beziehung zu setzen sowie belastbare Ergebnisse hervorbringt und schnell sowie einfach durchzuführen ist.

Dies wird erfindungsgemäß dadurch erreicht, dass

am zu vermessenden Objekt ein Dauermesspunkt eingerichtet wird, an dem eine Messung der Magnetfeldstärke über einen längeren Zeitraum, vorzugsweise 24 Stunden, um möglichst alle über einen Tag auftretenden betrieblichen Belastungen der stromführenden Einrichtung zu erfassen, durchgeführt wird. Parallel und zeitgleich zur Dauermessung werden an verschiedenen weiteren von der stromführenden Einrichtung gleichermaßen beeinflussten Messpunkten des zu vermessenden Objektes schrittweise mehrere jeweils sehr viel kürzere Vergleichsmessungen realisiert. Die Maximalwerte der Dauermessung werden zu den zeitgleichen Werten der Vergleichsmessungen und den absoluten Maximalmesswerten der Dauermessung nach folgender Formel in ein Verhältnis gesetzt,

$$MW_{x\,max} = \frac{MW_0\,(t_0) \bullet MW_x\,(t_x)}{MW_0\,(t_x)}$$

wobei

- Index 0 - Dauermessung am Messpunkt M0
- Index x -Vergleichsmessung am Messpunkt Mx
- $t_0$ - Zeitpunkt des Auftretens des Maximalwertes der Dauermessung
- $t_x$ - Zeitpunkt des Auftretens der jeweiligen Maximalwertes während einer Vergleichsmessung x
- MW - Messwert, bandpassgefiltert, Frequenz entsprechend der beeinflussenden Anlage (z.B. 16,7Hz, 50Hz)
- $MW_{x\,max}$ - höchster während des Zeitraums der Dauermessung am Ort der Vergleichsmessung bezogener Wert - (hochgerechnet)

bedeuten und anschließend die gesamte bezogene Magnetfeldbelastung des Messobjektes im Zeitraum der Dauermessung umfassend dargestellt wird.

Die Systemzeiten der Messgeräte werden im Rahmen einer Dauermessung durch einen Abgleich zeitlich exakt aufeinander abgestimmt.

Ein eventueller Gangunterschied der Messgeräte wird durch zeitliches Shifting ausgeglichen.

Die verschiedenen Vergleichsmessungen können mittels eines einzigen Messdaten-Erfassungsgerätes in zeitlicher Folge durchgeführt werden.

Die Daten von den Messgeräten können auch über Funk an ein Messdaten-Erfassungsgerät gesendet werden.

**Vorteile der Erfindung**

- durch die erfindungsgemäße Lösung ist es möglich, an unterschiedlichen Orten gleichzeitig Messwerte zu erfassen, die danach exakt zueinander in ein Verhältnis gesetzt werden können
- es ist eine schnelle und großflächige Erfassung stark schwankender niederfrequenter magnetischer Felder möglich
- es werden aufwendige Einzelmessungen an einer Vielzahl von Messpunkten vermieden. Jede dieser Einzelmessungen müsste, um systematische Fehler zu vermeiden, die durch die in der Regel auftretenden betrieblichen Schwankungen der Anlagen entstehen, über einen längeren Zeitraum, vorzugsweise 24 Stunden, durchgeführt werden.

Anhand eines Ausführungsbeispieles soll nachstehend die Erfindung näher erläutert werden.

An jedem Standort, für den die magnetische Belastung durch niederfrequente-Felder zu ermitteln ist, wird eine Vergleichsmessung mit einer Dauer von etwa 20 min durchgeführt. Parallel dazu läuft an einem Punkt mit der gleichen magnetischen Beeinflussungssituation (Identische Geometrie der beeinflussenden Anlage, Schaltzustand, Stromstärke und Frequenz), eine Dauermessung, die die magnetische Flussdichte über einen Zeitraum von 24 h aufzeichnet, um möglichst jeden vorkommenden betrieblichen Belastungszustand zu erfassen.

Die Messung der magnetischen Flussdichte erfolgt mithilfe von Magnetfeldanalysatoren, die den Messwert z.B. sekündlich in digitaler Form an ein Messdaten-Erfassungsgerät übermitteln, wo diese Messwerte gespeichert werden.

Zur Ermittlung der maximalen Belastung an einem Vergleichsmesspunkt werden Dauer- und Vergleichsmessung zueinander ins Verhältnis gesetzt und daraus für jeden Vergleichsmesspunkt ein Verstärkungs- bzw. Abschwächungsfaktor ermittelt. Durch Multiplikation mit dem Spitzenwert, der am Dauermesspunkt innerhalb von 24 h auftrat, kann so für jeden Vergleichsmesspunkt die maximale magnetische Flussdichte bestimmt werden.

Die höchsten Messwerte werden automatisch ermittelt und dokumentiert. Der höchste Wert der Dauermessung am Messpunkt M0 ist zum Zeitpunkt $t_0$ der Messwert **$MW_0\,(t_0)$**. Er wird zusammen mit der Uhrzeit in der Tabelle "Dauermessung" ausgewiesen.

- Der höchste Wert einer Vergleichsmessung am Messpunkt **Mx** ist zum Zeitpunkt $t_x$ der Messwert **$MW_x(t_x)$.**

- Um die Dauer- und Vergleichsmessung zueinander ins Verhältnis setzen zu können, wird zum Zeitpunkt $t_x$ am Dauermesspunkt **M0** der Messwert **$MW_0\,(t_x)$** bestimmt.

Ermittlung der Messergebnisse

Da zwischen der felderzeugenden Stromstärke und der Höhe des Magnetfeldes ein linearer Zusammenhang besteht, ist es möglich, die Messergebnisse von Dauer- und Vergleichsmesspunkten direkt durch eine Formel zueinander in Beziehung zu stellen.

Für die an den verschiedenen Vergleichsmesspunkten **Mx** erfassten Spitzenwerte der magnetischen Flussdichte **MW$_x$ (t$_x$)** werden die gleichzeitig am Dauermesspunkt MP$_0$ auftretenden Werte **MW$_0$ (t$_x$)** ermittelt und aufgezeigt. Unter Berücksichtigung der Messunsicherheit ist über das Verhältnis des momentanen Messwertes am **MW$_0$ (t$_x$)** und den absoluten Spitzenwert am **MW$_0$ (t$_0$)** ein Faktor zu bilden, der mit dem Spitzenwert am Vergleichsmesspunkt **MW$_x$ (t$_x$)** multipliziert, den bezogenen Spitzenwert am Vergleichsmesspunkt **MW$_{xmax}$** bildet.

$$\text{Formel :} \quad MW_{x\,max} = \frac{MW_0\,(t_0) \bullet MW_x\,(t_x)}{MW_0\,(t_x)}$$

**Beispiel:**

**Dauermessung:**
Beginn: 01.01.2000 12:00 Uhr
Ende: 02.01.2000 12:00 Uhr
Spitzenwert **MW$_0$ (t$_0$)** 40 $\mu$T (02.01.2000, 06:00 Uhr)
Vergleichswert **MW$_0$ (t$_x$)** 20 $\mu$T (01.01.2000, 13:05 Uhr)

**Vergleichsmessung:**
Beginn: 01.01.2000 13:00 Uhr
Ende: 01.01.2000 13:30 Uhr
Spitzenwert **MW$_x$(t$_x$):** 10 $\mu$T (01.01.2000, 13:05 Uhr)

Mithilfe dieser Daten kann die maximale hochgerechnete Belastung am Vergleichsmesspunkt **MW$_{x\,max}$** berechnet werden, die dort innerhalb von 24 h aufgetreten ist, und zwar um 6:00 Uhr morgens.

$$MW_{x\,max} = \frac{40\,\mu T \cdot 10\,\mu T}{20\,\mu T} = 20\,\mu T$$

Auf diese Weise lassen sich mit nur zwei Messgeräten die örtlichen Belastungen an vielen Orten (in der Regel werden sehr viele Vergleichsmessungen durchgeführt) eines großen Areals bestimmen, die dort innerhalb von 24 Stunden auftreten.

**Patentansprüche**

1. Verfahren zur großflächigen Erfassung stark schwankender niederfrequenter magnetischer Felder, insbesondere im Rahmen der Ermittlung einer elektromagnetischen Verträglichkeit im Bereich stromführender Einrichtungen, wobei hierfür an sich bekannte Messinstrumente verwendet werden, mit deren Hilfe die jeweilige Magnetfeldstärke an bestimmten Messpunkten eines zu vermessenden Objektes ermittelt wird,

**gekennzeichnet dadurch, dass** am zu vermessenden Objekt ein Dauermesspunkt eingerichtet wird, an dem eine Messung der Magnetfeldstärke über einen längeren Zeitraum, vorzugsweise 24 Stunden, durchgeführt wird, parallel und zeitgleich zur Dauermessung an verschiedenen weiteren von der stromführenden Einrichtung gleichermaßen beeinflussten Messpunkten des zu vermessenden Objektes schrittweise mehrere jeweils sehr viel kürzere Vergleichsmessungen realisiert werden, die Maximalwerte der Dauermessung zu den zeitgleichen Werten der Vergleichsmessungen und den absoluten Maximalmesswerten der Dauermessung nach folgender Formel in ein Verhältnis gesetzt werden,

$$MW_{x\,max} = \frac{MW_0(t_0) \bullet MW_x(t_x)}{MW_0(t_x)}$$

wobei

    a. Index 0 - Dauermessung am Messpunkt M0
    b. Index x -Vergleichsmessung am Messpunkt Mx
    c. $t_0$ - Zeitpunkt des Auftretens des Maximalwertes der Dauermessung
    d. $t_x$ - Zeitpunkt des Auftretens der jeweiligen Maximalwertes während einer Vergleichsmessung x
    e. MW - Messwert, bandpassgefiltert, Frequenz entsprechend der beeinflussenden Anlage (z.B. 16,7Hz, 50Hz)
    f. $MW_{x\,max}$ - höchster während des Zeitraums der Dauermessung am Ort der Vergleichsmessung bezogener Wert - (hochgerechnet)

bedeuten und anschließend die gesamte bezogene Magnetfeldbelastung des Messobjektes im Zeitraum der Dauermessung umfassend dargestellt wird.

2. Verfahren nach Anspruch 1, **gekennzeichnet dadurch, dass** für die einzelnen zeitgleichen Messungen im Minimum lediglich zwei Messeinrichtungen und ein Messdaten-Erfassungsgeräte verwendet werden.

3. Verfahren nach Anspruch 1 bis 2, **gekennzeichnet dadurch, dass** gewährleistet wird, dass die Systemzeiten der Messgeräte durch einen Abgleich zeitlich exakt aufeinander abgestimmt werden.

4. Verfahren nach Anspruch 1 bis 3, **gekennzeichnet dadurch, dass** ein eventueller Gangunterschied der Messgeräte durch zeitliches Shifting ausgeglichen wird.

5. Verfahren nach Anspruch 1 bis 4, **gekennzeichnet dadurch, dass** die verschiedenen Vergleichsmessungen mittels eines einzigen Messdaten-Erfassungsgerätes z.B. in zeitlicher Folge durchgeführt werden.

6. Verfahren nach Anspruch 1 bis 5, **gekennzeichnet dadurch, dass** Messungen und Nachweise für Felder in beliebig großen von der stromführenden Einrichtung gleichermaßen beeinflussten Arealen durchgeführt werden.

7. Verfahren nach Anspruch 1 bis 6, **gekennzeichnet dadurch, dass** sowohl für die Messdaten-Erfassungsgeräte als auch für die Messgeräte spezielle, transportable Energieversorgungsmodule angewendet werden, die einen flexiblen Einsatz der Geräte unabhängig von öffentlichen Stromversorgungsnetzen über lange Zeiträume beispielsweise von über 24 h ermöglichen.

8. Verfahren nach Anspruch 1 bis 7, **gekennzeichnet dadurch, dass** die Daten von den Messgeräten auch über Funk an ein Messdaten-Erfassungsgerät gesendet werden.

**Europäisches Patentamt**

**EUROPÄISCHER RECHERCHENBERICHT**

Nummer der Anmeldung

EP 07 01 9909

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JOHNSON G B: "Residential field source at power frequencies" ELECTROMAGNETIC COMPATIBILITY, 1993. SYMPOSIUM RECORD., 1993 IEEE INTERNATIONAL SYMPOSIUM ON DALLAS, TX, USA 9-13 AUG. 1993, NEW YORK, NY, USA,IEEE, 9. August 1993 (1993-08-09), Seiten 132-137, XP010149654 ISBN: 0-7803-1304-6 * Abbildungen 1-5,7-9,13 * * Seite 132, linke Spalte, Absatz 1 - Seite 133, rechte Spalte, Absatz 2 * * Seite 135, linke Spalte, Absatz 2 - rechte Spalte, letzter Absatz * ----- | 1-8 | INV. G01R29/08 |
| X | US 5 717 388 A (JANOSKA MARK A [US] ET AL) 10. Februar 1998 (1998-02-10) * Abbildungen 1,2,4-14 * * Spalte 1, Zeile 5 - Spalte 4, Zeile 20 * * Spalte 6, Zeile 11 - Spalte 9, Zeile 27 * ----- | 1-8 | |
| | | | RECHERCHIERTE SACHGEBIETE (IPC) |
| X | T. VINH ET AL.: "Magnetic Fields Near Overhead Distribution Lines - Measurements And Estimating Technique" IEEE TRANSACTIONS ON POWER DELIVERY, Bd. 6, Nr. 2, April 1991 (1991-04), Seiten 912-921, XP002468895 * Abbildungen 2-5 * * Seite 912, linke Spalte, Absatz 1 - Seite 914, linke Spalte, Absatz 2 * ----- -/-- | 1-8 | G01R |

Der vorliegende Recherchenbericht wurde für alle Patentansprüche erstellt

| Recherchenort | Abschlußdatum der Recherche | Prüfer |
|---|---|---|
| Berlin | 14. Februar 2008 | Höller, Helmut |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...............................................................
& : Mitglied der gleichen Patentfamilie, übereinstimmendes Dokument

EPO FORM 1503 03.82 (P04C03)

Europäisches
Patentamt

**EUROPÄISCHER RECHERCHENBERICHT**

Nummer der Anmeldung

EP 07 01 9909

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 03/087857 A (ACKERMANN PATENT GMBH [CH]; ACKERMANN RENE [CH]) 23. Oktober 2003 (2003-10-23) * Abbildungen 2,4,8a-20 * * Seite 3, Absatz 3 * * Seite 9, Absatz 2 - Seite 12, Absatz 1 * * Seite 17, letzter Absatz - Seite 20, letzter Absatz *  ----- | 1-8 | |
| A | US 2005/162148 A1 (STAATS PRESTON T [US] STAATS PRESTON TRENT [US]) 28. Juli 2005 (2005-07-28) * Abbildung 3 * * Absatz [0010] - Absatz [0011] * * Absätze [0013], [0028], [0029] * * Absätze [0037], [0067] * * Absatz [0077] - Absatz [0090] * * Absatz [0138] - Absatz [0139] *  ----- | 1-8 | |
| A | NEUMANN M: "ELEKTROSMOG MESSEN" FUNKSCHAU, WEKA FACHZEITSCHRIFTEN VERLAG, POING, DE, Nr. 11, 9. Mai 1997 (1997-05-09), Seiten 78-81, XP000728950 ISSN: 0016-2841 * das ganze Dokument *  ----- | 1 | RECHERCHIERTE SACHGEBIETE (IPC) |
| A | DE 198 09 076 A1 (HAASE [DE]) 9. September 1999 (1999-09-09) * das ganze Dokument *  ----- | 1 | |
| A | STEFFEN JANK ET AL.: "Beeinflussung von Anlagen der Leit- und Sicherungstechnik durch Bahnströme" BAHN PRAXIS E, Februar 2006 (2006-02), Seiten 5-8, XP002468896 * Seite 5 - Seite 8 *  ----- | 1 | |

Der vorliegende Recherchenbericht wurde für alle Patentansprüche erstellt

| Recherchenort | Abschlußdatum der Recherche | Prüfer |
|---|---|---|
| Berlin | 14. Februar 2008 | Höller, Helmut |

EPO FORM 1503 03.82 (P04C03)

**EP 1 918 724 A1**

## ANHANG ZUM EUROPÄISCHEN RECHERCHENBERICHT
## ÜBER DIE EUROPÄISCHE PATENTANMELDUNG NR.

EP 07 01 9909

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-02-2008

| Im Recherchenbericht angeführtes Patentdokument | | Datum der Veröffentlichung | Mitglied(er) der Patentfamilie | | Datum der Veröffentlichung |
|---|---|---|---|---|---|
| US 5717388 | A | 10-02-1998 | CA | 2203747 A1 | 25-10-1997 |
| WO 03087857 | A | 23-10-2003 | AU | 2003218847 A1 | 27-10-2003 |
| | | | EP | 1495338 A2 | 12-01-2005 |
| US 2005162148 | A1 | 28-07-2005 | US | 2004263149 A1 | 30-12-2004 |
| DE 19809076 | A1 | 09-09-1999 | KEINE | | |

EPO FORM P0461

Für nähere Einzelheiten zu diesem Anhang : siehe Amtsblatt des Europäischen Patentamts, Nr.12/82

8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1445619 A1
- DE 10062292 A1